**Europäisches Patentamt**

(19) **European Patent Office**

**Office européen des brevets**

(11) Numéro de publication: **0 022 695**
**B1**

(12) **FASCICULE DE BREVET EUROPEEN**

(45) Date de publication du fascicule du brevet:
**18.04.84**

(21) Numéro de dépôt: **80400944.7**

(22) Date de dépôt: **24.06.80**

(51) Int. Cl.³: **H 03 H 19/00**

(54) **Ensemble de filtrage par commutation.**

(30) Priorité: **29.06.79 FR 7916913**

(43) Date de publication de la demande:
**21.01.81 Bulletin 81/3**

(45) Mention de la délivrance du brevet:
**18.04.84 Bulletin 84/16**

(84) Etats contractants désignés:
**DE GB IT NL**

(56) Documents cités:
**EP - A - 0 014 628**
**FR - A - 2 294 588**
**GB - A - 1 254 223**
**US - A - 3 531 741**

**IEEE TRANSACTIONS ON AEROSPACE AND**
**ELECTRONIC SYSTEMS, vol. AES-5; no. 1, janvier 1969**
**NEW YORK (US) M.T. BORELLI: "Analysis of**
**commutated networks employing feedback circuits",**
**pages 39-45**

(73) Titulaire: **COMMISSARIAT A L'ENERGIE ATOMIQUE**
**Etablissement de Caractère Scientifique Technique et**
**Industriel, B.P. 510, F-75752 Paris Cedex 15 (FR)**

(72) Inventeur: **Gignoux, Michel, "La Charrière Froide",**
**F-38760 Saint Paul de Varces (FR)**

(74) Mandataire: **Mongrédien, André et al, c/o**
**BREVATOME 25, rue de Ponthieu, F-75008 Paris (FR)**

Ensemble de filtrage par commutation

La présente invention concerne un ensemble de filtrage par commutation, utilisant des filtres de type série, à «chemins commutés», de tpye passe-bande; cette invention s'applique au filtrage d'un signal présentant une composante utile de fréquence variable, associée à un bruit de fond important; elle s'applique également à la sélection d'un signal périodique mélangé à un autre signal, à l'analyse harmonique, aux télécommunications, etc...

On sait que des filtres passe-bande très sélectifs peuvent être réalisés très facilement en utilisant des structures dites à N chemins commutés comprenant chacun une résistance associée à un condensateur et à deux commutateurs, comme on le verra plus loin en détail, ces structures peuvent être résuites à un circuit équivalent à N chemins dans lequel chaque chemin comprend seulement un condensateur associé à deux commutateurs, tandis que l'ensemble des chemins présente une résistance commune d'entrée. Ce circuit équivalent est souvent qualifié de «filtre à N chemins, de type série, à commutation de capacités». Ce type de filtre a pour principal avantage de présenter une réponse en «peigne», de présenter une bande de largeur réglable et d'être accordable en fréquence grâce aux impulsions d'une horloge externe. Cette dernière propriété permet, en technologie micro-électronique, de réaliser des filtres dont la structure est intégrable. Les filtres à étalon de fréquence externe sont moins sensibles que les autres filtres aux variations des valeurs des éléments qui les constituent; le réglage externe de leur fréquence d'accord ainsi que leur synchronisation par un signal extérieur sont réalisés simplement. La fréquence centrale de la dent principale de la courbe de réponse de ces filtres en peigne, est définie par la fréquence $H_1$ de l'horloge externe, tandis que la largeur de cette dent principale à $-3$ décibels, reste constante quelle que soit la fréquence $H_1$. Cette largeur peut être définie par la relation

$$B = \frac{1}{\pi NRC}$$

dans laquelle N représente le nombre de chemins, R la résistance commune à l'ensemble des chemins et C la capacité résultante de chacun des chemins. Cette relation montre clairement que l'obtention d'une bande passante très étroite avec un filtre de ce type nécessite que le produit NRC soit important. En micro-électronique, il est facile d'accroître le nombre N des chemins du filtre, mais malheureusement, cet accroissement entraîne l'occupation d'une place importante, ce qui est un inconvénient majeur puisque cette place est précieuse dans la technologie des semiconducteurs intégrés. De plus, l'augmentation du nombre des chemins d'un filtre en peigne conduit simultanément à augmenter la fréquence de l'horloge de commande externe, ce qui pour une technologie donnée, peut aboutir à limiter la fréquence haute du filtre. Il est également possible, pour diminuer la largeur de la bande passante, d'augmenter la valeur de résistance commune à l'ensemble des chemins; de manière connue, cette résistance peut être remplacée par des condensateurs commutés. Cette technique nécessite l'utilisation d'une seconde horloge délivrant des impulsions de fréquence $H_2$, mais permet d'obtenir des valeurs très élevées de la résistance. Cependant, comme l'obtention d'une résistance de valeur élevée n'est possible que pour des fréquences basses de commutation, l'application du théorème de Shannon montre que l'utilisation de cette technique peut limiter la fréquence haute du signal à filtrer. Enfin, la résistance ainsi synthétisée, sous forme de capacités commutées étant proportionnelle au temps de commutation, la fréquence haute du filtre risque aussi de se trouver limitée. Un autre inconvénient de cette technique résulte du fait que les capacités commutées présentent une imprécision assez importante, ce qui risque, bien entendu, de provoquer une imprécision de la largeur de la bande passante du filtre considéré.

De tels filtres sont décrits par exemple dans le brevet US 3 531 741 et dans la revue IEEE transactions – volume AES 5 n° 1 – janvier 1969 – page 41, article «Analysis of commutated networks employing feedback circuits» pages 39–45.

Il résulte de ces observations qu'un filtre à commutation périodique de capacités est généralement encombrant, difficile à intégrer en microélectronique et présente une bande passante dont la finesse est limitée par la fréquence des signaux de commutation.

La présente invention a pour but de remédier à ces inconvénients et notamment de réaliser un ensemble de filtrage dans lequel l'obtention d'une bande passante très étroite ne nécessite pas un accroissement gênant du nombre des chemins des filtres à commutation utilisés et pour lequel il est possible d'utiliser une résistance commune aux différents chemins, synthétisée sous forme de capacités commutées, sans que l'application du théorème de Shannon ne limite excessivement la fréquence haute de cet ensemble de filtrage.

La présente invention a pour objet un ensemble de filtrage de signaux utiles permanents par commutation comprenant un premier filtre à N-chemins à commutation série, apte à recevoir des signaux à filtrer et des moyens pour appliquer à chacun des chemins, des signaux de commande de commutation de ces chemins, un circuit mélangeur dont une première entrée reçoit à un instant considéré, le signal à filtrer et dont une deuxième entrée reçoit, à cet instant considéré, la valeur qu'avait le signal filtré à la sortie de l'ensemble, un instant auparavant, la sortie de ce circuit mélangeur étant reliée à l'entrée dudit premier filtre, caractérisé en ce qu'il comprend au moins un deuxième filtre à N-chemins à commutation série, relié en série avec le premier filtre, la sortie du premier filtre étant reliée à l'entrée du deuxième filtre, la sortie du deuxième filtre étant reliée à la sortie de l'ensemble de filtrage, lesdits moyens appliquant aussi des signaux de commande des commutations des chemins du deuxième filtre, étant constitués de manière à commander les commutations pour que la somme des décalages temporels entre le signal de sortie du deuxième filtre et le signal d'entrée du premier filtre soit égal à un nombre entier de fractions de périodes T de la composante utile du signal d'entrée du premier filtre.

Dans ces conditions, l'amplitude du signal filtré de sortie sera maximale; mais il est clair que si le décalage temporel n'est pas rigoureusement égal à un nombre entier de périodes, l'ensemble de filtrage fonctionne tout de même, l'amplitude seule du signal de sortie étant diminuée.

Selon une autre caractéristique, les deux filtres comprennent un nombre identique N de chemins, chacun desdits décalages étant à un nombre en tier de demi-périodes $\dfrac{T}{2}$ de la composante utile du signal d'entrée du premier filtre.

Selon un premier mode de réalisation de l'invention, le circuit mélangeur comprend un amplificateur opérationnel non inverseur dont la sortie est reliée à l'entrée du premier filtre, cet amplificateur présentant un circuit de contre-réaction sur l'une de ses entrées, l'autre entrée de cet amplificateur recevant le signal à filtrer par l'intermédiaire d'une première résistance, cette entrée étant en outre reliée à la sortie du deuxième filtre par l'intermédiaire d'une deuxième résistance, le rapport des valeurs de ces résistances déterminant le coefficient de pondération du signal de sortie du mélangeur, dans la corrélation des signaux d'entrées.

Selon un second mode de réalisation de l'invention, le mélangeur est un commutateur à deux positions commandables électriquement, présentant deux bornes d'entrée et une borne de sortie, cette borne de sortie étant reliée à l'entrée du premier filtre, la première borne d'entrée du commutateur recevant le signal à filtrer et l'autre borne d'entrée recevant le signal de sortie du deuxième filtre, ce commutateur étant commandé par des moyens de commande de commutation constitués de manière à mettre en communication l'entrée du premier filtre avec la sortie du deuxième filtre.

Dans ce cas, on peut commander la commutation du commutateur à deux positions à une fréquence élevée (10 fois plus par exemple) par rapport à la fréquence de commutation des chemins du filtre.

On peut aussi utiliser la même horloge pour commander le commutateur et les deux filtres à commutation; dans ce cas, les moyens de commande de commutation du commutateur sont tels que l'on met en communication l'entrée du premier filtre avec la sortie du deuxième filtre pendant un intervalle de temps centré sur le milieu de l'intervalle de temps pendant lequel on établit l'un des N chemins de chacun des filtres à commutation.

Dans les deux cas, la durée relative des temps passés sur les deux positions détermine le coefficient de pondération du mélange.

Selon une autre caractéristique de la seconde variante, la première borne d'entrée du commutateur à deux positions reçoit le signal à filtrer par l'intermédiaire d'une première résistance tandis que la deuxième borne d'entrée reçoit le signal de sortie du deuxième filtre par l'intermédiaire d'une deuxième résistance, le rapport des valeurs de ces résistances déterminant également le coefficient de pondération du signal de sortie du mélangeur dans la corrélation des signaux d'entrées.

Selon une autre caractéristique, l'ensemble formé par le commutateur à deux positions et par les première et deuxième résistances, est simulé par des capacités commutées périodiquement.

Selon une autre caractéristique les filtres et mélangeur sont réalisés sous forme de circuits intégrés sur substrat semi-conducteur.

Enfin selon une autre caractéristique, lesdits circuits intégrés sont des circuits de type MOS.

D'autres caractéristiques et avantages de l'invention ressortiront encore de la description qui va suivre, donnée à titre purement illustratif, en référence aux dessins annexés dans lesquels:

la figure 1 représente:

en a) un filtre à commutation à N chemins, de type série, connu dans l'état de la technique et utilisé dans l'ensemble de filtrage de l'invention.

En b) un filtre équivalent du filtre à commutation de type série, précédent;

la figure 2 est un diagramme illustrant la fonction de transfert $F_T$ de l'un des filtres précédents, en fonction de la fréquence F du signal à l'entrée de ce filtre;

la figure 3 représente schématiquement un ensemble de filtrage conforme à l'invention;

la figure 4 représente schématiquement un mode de réalisation du mélangeur qui intervient dans l'ensemble de filtrage de l'invention;

la figure 5 représente schématiquement un autre mode de réalisation de ce mélangeur;

la figure 6 représente schématiquement un autre mode de réalisation du mélangeur de la figure 5.

la figure 7 représente un autre mode de réalisation du filtre, incluant une capacité mémoire.

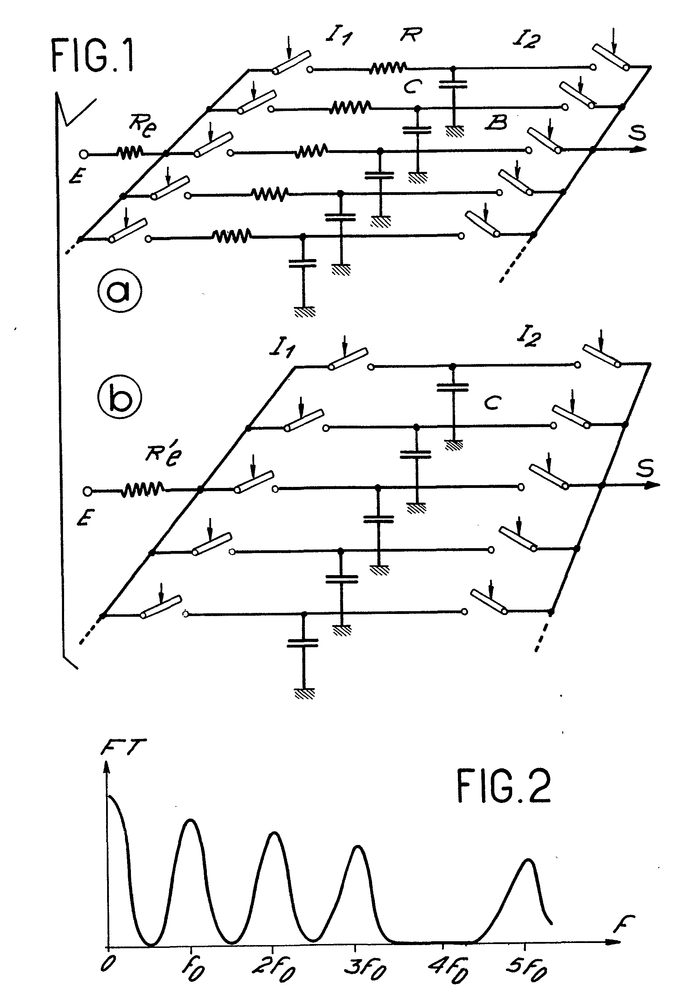

En référence à la figure 1 on a représenté en (a) un filtre à commutation à N chemins de type série, connu dans l'état de la technique et utilisé, comme on le verra par la suite, dans l'ensemble de filtrage de l'invention.

Ce filtre comprend une résistance d'entrée $R_e$ reliée en série avec N cellules de filtrage présentes respectivement sur N chemins commutables par l'intermédiaire de commutateurs commandables tels que $I_1$, $I_2$. Chaque cellule de filtrage, dans l'exemple de réalisation représenté, est constituée par une résistance R associée à un condensateur C dont l'une des bornes est portée à un potentiel de référence B. Le signal d'entrée à filtrer est appliqué à l'entrée E du filtre, tandis que le signal filtré de sortie est obtenu en S. Ce type de filtre à commutation de type série, connu dans l'état de la technique, peut être qualifié de filtre à commutation à N chemins échantillonnés de manière répétitive; il est très sélectif et il fonctionne en prélevant une partie du signal d'entrée successivement sur les N chemins disposés en travers du passage de ce signal. Généralement, les cellules de filtrage ces différents chemins sont identiques et les instants où l'on prélève le signal dans chaque chemin sont régulièrement répartis dans le temps et ne se recoupent pas lorsque l'on passe d'un chemin au suivant, d'une manière cyclique. On n'a pas représenté sur cette figure les moyens connus qui permettent de commander les commutateurs $I_1$, $I_2$, de manière cyclique; ces moyens peuvent être constitués de circuits logiques, tandis que les commutateurs $I_1$, $I_2$ commandables, peuvent être constitués par des transistors à effet de champ. Comme les N chemins sont commutés cycliquement et se succèdent en travers du passage du signal, la réponse du filtre n'est pas indépendante du temps. Si la constante de temps de chaque cellule de filtrage de chaque chemin est grande vis-à-vis du temps de commutation, la fonction de transfert résultante est symétrique par rapport à la fréquence de commutation. Si le signal sinusoïdal appliqué à l'entrée du filtre présente une composante fondamentale de fréquence $f_0$, à chaque période, chaque capacité C est sollicitée par la valeur du signal qui lui revient au cours du cycle. Cette valeur ne change pas si la commutation est synchrone de la composante fondamentale du signal d'entrée. Chaque capacité se charge pendant l'intervalle de temps qui lui est imparti au cours des commutations et cette charge est maintenue pendant le reste du temps. En régime établi, chaque capacité rejoint la valeur du signal à laquelle elle est sollicitée. En sortie du filtre, le signal obtenu est une forme approchée du signal d'entrée, par valeurs discrètes, régulièrement réparties. Les caractéristiques du filtre passe-bande ainsi réalisé et représenté sur la figure sont déterminées par les éléments du filtre passe-bas constitué par chaque cellule de chaque chemin. La sélectivité ou la bande passante de ce filtre à N chemins commutés dépend bien entendu du nombre N. L'effet de l'échantillonnage sur les cellules de filtrage passe-bas de chaque chemin produit en fait, non pas une seule réponse passe-bas centrée sur la fréquence fondamentale $f_0$ du signal d'entrée, mais toute une série de bandes centrées sur les harmoniques de la fréquence $f_0$ et sur la fréquence 0.

Comme on le verra par la suite, la forme générale de la réponse de ce filtre à commutation à N chemins est caractéristique de l'échantillonnage. En particulier, si N est le nombre de chemins, le système a une réponse nulle pour les fréquences $Nf_0$, $2Nf_0$, etc..., c'est pour cette raison que ces filtres sont souvent appelés «filtres en peigne» et que l'on désigne par dents du peigne les raies centrées sur les fréquences $f_0$, $2f_0$, etc...

On a représenté en (b), un schéma équivalent du filtre à commutation de type «série», précédent. Sur ce schéma équivalent, la résistance d'entrée $R'_e$ est la résistance équivalente à la résistance d'entrée $R_e$ et à la résistance R de chacun des chemins; le filtre équivalent ainsi obtenu est bien un filtre de type «série» puisque les portes ou commutateurs d'échantillonnage $I_1$ et $I_2$ sont disposés entre l'entrée E et la sortie S du signal. Cette disposition a pour principal avantage de placer les résistances de passage des commutateurs $I_1$ et $I_2$ de chaque chemin, en série avec l'élément purement résistif $R'_e$ et de conserver à l'élément C son caractère purement réactif. Les commutateurs $I_1$ et $I_2$ peuvent être actionnés, soit simultanément, soit avec un certain décalage fixe dans le temps. Il en résulte alors un déphasage fixe à la sortie; seule cette disposition de type «série» permet ce déphasage. Comme on le verra plus loin en détail, la résistance $R'_e$ peut être synthétisée sous forme de capacités commutées.

Le filtre à commutation à N chemins de type série qui vient d'être décrit sur les figures 1a et 1b peut être qualifié de filtre en peigne; il peut être facilement transformé en filtre à commutation de N chemins, de type passe-bande, lorsqu'il est suivi d'un filtre passe-bande grossier, suffisant pour ne favoriser que l'une des raies du peigne.

En référence à la fig. 2, on a représenté un diagramme illustrant la fonction de transfert $F_T$ de l'un des filtres précédents, en fonction de la fréquence f du signal parvenant à l'entrée de ce filtre. Comme on l'a expliqué précédemment, les filtres décrits sur les figures précédentes sont des filtres passe-bande, dits en «peigne», pour lesquels la fonction de transfert résultante est symétrique par rapport à la fréquence de commutation $f_0$. L'une des originalités de ces filtres est que si l'on change la fréquence $f_0$ de commutation, on change la fréquence centrale du filtre passe-bande à N chemins commutés, sans changer la largeur de la bande. Cependant, comme on l'a déjà indiqué, la dénomination de filtre en peigne vient du fait que l'échantillonnage produit non pas une seule réponse passe-bande centrée sur $f_0$, mais toute une série de bandes centrées sur les harmoniques de $f_0$ et la fréquence 0, comme le montre la fig. 2. La fonction de transfert représentée sur la fig. 2 est caractéristique d'un filtre échantillonné, à quatre chemins. Les dents du peigne désignent les raies en $f_0$, $2f_0$, etc... La durée relative des échantillonnages n'est pas critique. C'est la somme des durées de ces échantillons qui doit être strictement égale à la période $T_0$ du fondamental du signal d'entrée, sous peine d'élargissement de la raie à la fréquence $f_0$.

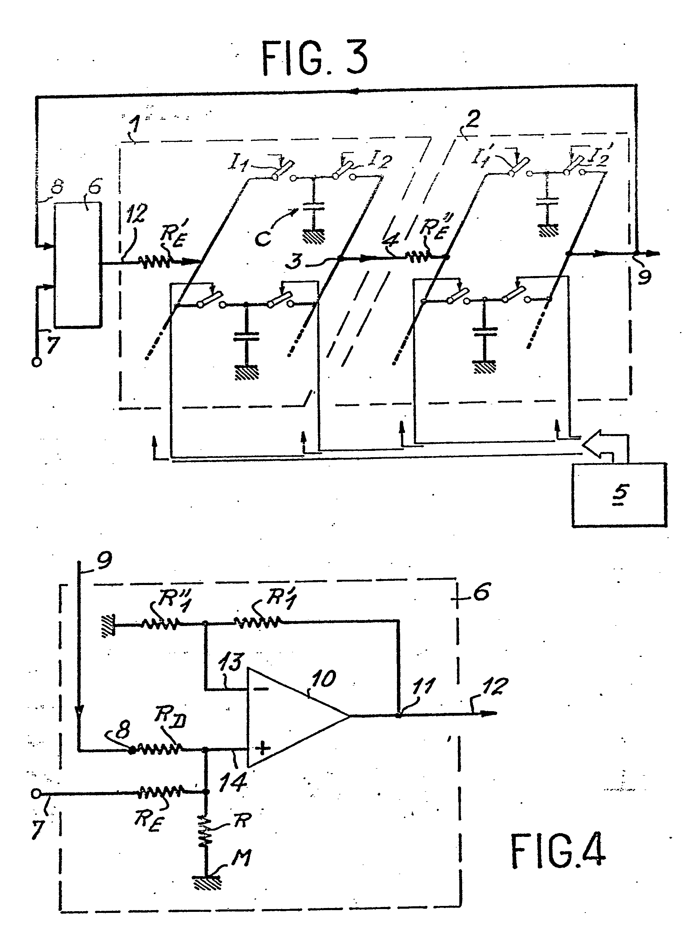

En référence à la fig. 3, on a représenté schématiquement un ensemble de filtrage par commutation conforme à l'invention et comprenant au moins deux filtres 1, 2, de type série, à chemins commutés; chacun de ces filtres qui n'est pas représenté en détail sur la fig., présente une structure équivalente comparable à celle du filtre équivalent représenté sur la fig. 1(b). La sortie 3 du premier filtre est reliée à l'entrée 4 du deuxième filtre et des moyens 5 permettent d'appliquer à chacun de ces filtres et notamment aux interrupteurs $I_1$ et $I_2$, représentés sur la fig. 1, des signaux de commande des commutations des chemins de chaque filtre. Cet ensemble de filtrage comprend en outre un circuit mélangeur 6 qui sera décrit plus loin en détail et dont une première entrée 7 reçoit le signal à filtrer tandis qu'une deuxième entrée 8 est reliée à la sortie 9 du deuxième filtre 2; cette sortie 9 constitue également la sortie de l'ensemble de filtrage. Les interrupteurs qui permettent la commutation des chemins, sous la commande des moyens 5, sont représentés en $I_1$, $I_2$ pour le filtre 1, tandis qu'ils sont représentés en $I'_1$, $I'_2$ pour le filtre 2. Les résistances communes à l'ensemble des chemins sont référencées $R'_E$ et $R''_E$, pour chacun des filtres 1, 2. Ainsi, qu'on va le voir, l'ensemble de filtrage conforme à l'invention utilisant deux filtres à commutation, de type série, connectés en série et associés à un mélangeur, nécessite, pour améliorer commodément le coefficient de surtension du filtrage, des décalages temporels entre les deux signaux d'entrée du mélangeur; ces décalages peuvent atteindre une ou plusieurs périodes des signaux d'entrée. La description du fonctionnement du filtre 1 va maintenant permettre de mieux comprendre comment ce décalage temporel d'une ou plusieurs périodes peut être réalisé. Cette description du fonctionnement du filtre 1 est bien entendu applicable au fonctionnement du filtre 2. Le filtre 1, de type série, représenté sur la figure peut par exemple comporter N chemins. Chacun de ces chemins comprend, de part et d'autre du condensateur de filtrage C, des commutateurs $I_1$ et $I_2$, qualifiés respectivement de commutateurs d'écriture et de lecture. Les commutateurs $I_1$ d'entrée, sont fermés successivement à une cadence T et chacun d'eux reste fermé pendant un temps $\Theta$; ce temps $\Theta$ pendant lequel chacun des commutateurs reste sur une position qui le rend passant, doit être inférieur au temps T qui sépare la sélection de deux chemins successifs, pour qu'il n'y ait pas recouvrement dans l'échantillonnage des signaux parvenant à l'entrée 7 de l'ensemble de filtrage. Ainsi, le signal d'entrée est aiguillé à travers le mélangeur 6 vers l'un des N chemins du filtre 1. Il est bien évident que le signal filtré à la sortie 3 du filtre 1, subit un échantillonnage comparable dans le filtre 2. Les commutateurs $I_1$ sont qualifiés de commutateurs d'écriture puisqu'ils permettent la mémorisation d'un échantillon du signal d'entrée, dans chacun des condensateurs C des chemins du filtre. Les interrupteurs $I_2$ situés du côté de la sortie 3 du filtre, après les condensateurs C, peuvent être qualifiés de commutateurs de lecture; ces commutateurs sont actionnés de la même manière et à la même cadence T que les commutateurs $I_1$ et ils permettent de mettre en communication chacun des condensateurs C, avec la sortie du filtre, en synchronisme avec la fermeture des commutateurs $I_1$, pendant la même durée de fermeture $\Theta$. Les commutateurs $I_2$, qualifiés de commutateurs de lecture, tout en restant actionnés à la même cadence T, pourraient être commandés par les moyens de commande 5, de manière à mettre en communication chacun des condensateurs des chemins du filtre, avec la sortie de ce filtre, pendant un intervalle de temps toujours égal à $\Theta$, mais avec un décalage temporel entre la fermeture des interrupteurs $I_1$ et la fermeture des interrupteurs $I_2$. Ceci peut être réalisé lorsque les commutateurs $I_1$ et $I_2$ sont actionnés par les mêmes signaux d'horloge provenant des moyens de commande 5, mais dans un ordre différent. Cet ordre peut notamment introduire un décalage temporel constant dans les signaux de commande de fermeture des interrupteurs $I_1$, $I_2$; de préférence, ce décalage temporel correspond à un multiple de la cadence T à laquelle sont fermés les commutateurs d'entrée. En fait, les signaux de commande des commutateurs de sortie se trouvent décalés dans le temps, d'un nombre entier d'intervalles de temps T, compris entre 1 et N−1, par rapport aux signaux de commande des commutateurs d'entrée. Lorsque ce décalage ou ce retard entre les signaux de commande des commutateurs de sortie et des commutateurs d'entrée est fixé à $\dfrac{N}{2} \times T$, le décalage temporel entre le signal de sortie du filtre et le signal d'entrée est égal à une demi-période de ce signal d'entrée. Si ce signal est sinusoïdal, ce décalage temporel correspond à un déphasage de 180° entre le signal de sortie et le signal d'entrée du filtre. Ce raisonnement est bien entendu applicable au filtre 2. Cependant, il est impossible, comme on vient de le voir, avec le filtre 1 seul, de réaliser un décalage ou un retard supérieur à $(N-1).T$. En effet, un retard supérieur à NT peut s'écrire sous la forme $(n + kN)T$ et il en résulte qu'après k périodes du signal d'entrée, le retard introduit entre le signal de sortie et le signal d'entrée est égal à nT, avec $1 < n < N-1$. Dans ces relations, N désigne bien entendu un nombre entier correspondant au nombre de chemins du filtre 1 considéré et n désigne aussi un nombre entier. Il résulte de ces observations qu'il est impossible de réaliser un retard d'une période entière du signal d'entrée, avec un seul filtre à commutation à N chemins. L'ensemble de filtrage de l'invention qui associe un filtre 2 à commutation, au filtre 1 décrit précédemment, permet de réaliser ce décalage d'une période entre le signal filtré et le signal d'entrée. Lorsque les deux filtres 1 et 2 décalent chacun d'une demi-période le signal qu'ils reçoivent à leur entrée, le signal de sortie de l'ensemble de filtrage est décalé d'une période par rapport au signal d'entrée. Avec cette disposition, on retrouve simultanément, à l'entrée le signal à l'instant présent, et à la sortie le signal qui s'est produit à la période précédente. La sortie 9 du deuxième filtre 2 étant rebouclée sur l'entrée 8 du mélangeur 6, il en résulte que l'ensemble de filtrage obtenu est analogue à un filtre de type récursif; cet ensemble de filtrage présente un coefficient de pondération introduit par le mélangeur 6 dans la corrélation des signaux que celui-ci reçoit sur ses entrées. La sélectivité, et donc le temps de réponse de l'ensemble de filtrage conforme à l'invention, dépendent de ce coefficient de pondération. Si le mélange des signaux d'entrée et de sortie du filtre est tel que la proportion du signal de sortie, dans ce mélange, est nulle, le filtre se comporte comme un filtre à N chemins, équivalent à deux filtres à N chemins reliés en série. Bien entendu, on suppose dans ce cas que les filtres 1 et 2 sont identiques et comportent le même nombre N de chemins. Si au contraire, le mélangeur 6 admet une proportion de plus en plus grande du signal retardé de sortie, par rapport au signal direct d'entrée, la réponse de l'ensemble de filtrage tend vers l'infini. L'invention permet donc d'accroître à volonté, et dans de grandes proportions, la sélectivité du filtre à commutation de départ, grâce à son association avec un second filtre à commutation. Un exemple peut être donné: on utilise deux filtres à 16 chemins, identiques et de constante de temps mesurée de 1,6 seconde; on les associe selon l'invention en utilisant un commutateur à deux positions de durées égales et en respectant la condition de centrage des commutations du commutateur et d'établissement des chemins, exprimée page 4; on obtient alors un ensemble de filtrage dont la constante de temps mesurée est de 160 secondes.

Dans l'ensemble de filtrage qui vient d'être décrit, les deux filtres 1 et 2 sont supposés identiques et commandés à la même cadence par des signaux de commande de fermeture des commutateurs présentant la même durée; ces commutateurs sont de plus, commandés dans le même ordre, mais avec un décalage temporel égal à une demi-période du signal fondamental d'entrée. Enfin, les fréquences centrales des deux filtres 1 et 2 sont identiques. Cependant, dans un autre mode de réalisation, la somme des décalages introduits par chacun des filtres peut être équivalente à un nombre entier de périodes du signal reçu à l'entrée de l'ensemble de filtrage, sans que les deux filtres à commutation de type série présentent le même nombre de commutateurs ni la même réponse temporelle; en effet, ces deux filtres doivent être seulement centrés sur la même fréquence. Il est simplement plus pratique de n'utiliser que deux filtres à commutation de type série, qui présentent le même nombre N de commutateurs. Dans la suite de la description, on supposera que les deux filtres sont identiques, de manière à faciliter la compréhension du fonctionnement de l'ensemble de filtrage de l'invention.

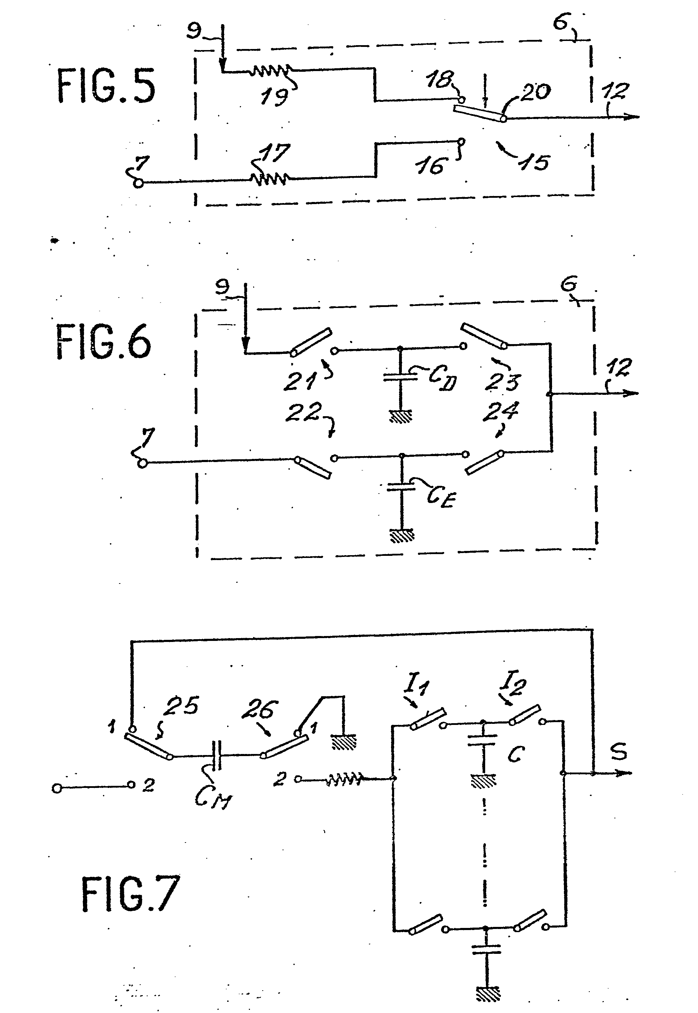

En référence à la fig. 4, on a représenté schématiquement un premier mode de réalisation du mélangeur 6. Dans ce premier mode de réalisation, le mélangeur 6 comprend un amplificateur opérationnel 10, non inverseur, dont la sortie 11 est reliée à l'entrée 12 du filtre 1. Cet amplificateur opérationnel présente un circuit de contre-réaction sur l'une de ses entrées 13; ce circuit de contre-réaction est constitué de manière connue par deux résistances $R'_1$ et $R''_1$. L'autre entrée 14 de l'amplificateur opérationnel reçoit le signal à filtrer, en 7, par l'intermédiaire d'une résistance $R_E$, tandis que le signal de la sortie 9 de l'ensemble de filtrage est reçu sur l'entrée 14, par l'intermédiaire d'une deuxième résistance $R_D$. Une résistance R relie, de manière connue, l'entrée 14 de l'amplificateur opérationnel 10 à une masse de référence M.

Si l'on désigne par S l'amplitude moyenne du signal de sortie de l'ensemble de filtrage, par S' l'amplitude moyenne du signal de sortie de l'amplificateur opérationnel 10, par E l'amplitude moyenne du signal d'entrée de l'ensemble de filtrage, il est possible d'écrire, de manière connue;

$$S' = \frac{E.R}{R_E + R} + \frac{S.R}{R_D + R}$$

Cette relation montre que le coefficient de pondération du mélangeur ainsi constitué correspond au rapport des résistances d'entrée $R_E$ et $R_D$ de l'amplificateur opérationnel 10.

En référence à la figure 5, on a représenté schématiquement, un autre mode de réalisation du mélangeur 6. Selon cet autre mode de réalisation, le mélangeur est constitué par un commutateur 15 à deux positions, commandables électriquement, à partir de signaux de commande provenant par exemple de moyens de commande 5 (fig. 1). Ce commutateur peut être constitué par un montage comprenant des transistors à effet de champ. La première borne 16 de ce commutateur reçoit le signal à filtrer, par l'intermédiaire d'une résistance 17 par exemple, tandis que la deuxième borne 18 de ce commutateur reçoit le signal de la sortie 9 du deuxième filtre, par l'intermédiaire d'une deuxième résistance 19. La borne de sortie 20 du commutateur est reliée à l'entrée 12 du premier filtre 1. Dans cet autre mode de réalisation du mélangeur 6, la pondération du signal de sortie du mélangeur dans la corrélation des signaux qu'il reçoit sur ces entrées est déterminée en réglant le temps relatif passé sur l'une ou l'autre des positions de commutation. Si la position de commutation 18 est maintenue plus longtemps que la position de commutation 16, il y a dans le signal de sortie du mélangeur une prépondérance du signal retardé, par rapport au signal d'entrée; il en résulte que le temps de réponse de l'ensemble de filtrage est accru. Si, au contraire, le commutateur demeure plus longtemps dans la position 16 que dans la position 18, il y a prépondérance du signal d'entrée dans le signal de sortie de l'ensemble de filtrage. Dans un cas limite, si le commutateur 15 reste constamment sur la position 18, l'ensemble de filtrage se comporte comme une mémoire infinie (aux imperfections technologiques près), tandis que si le commutateur est maintenu constamment dans la position 16, l'ensemble de filtrage se comporte comme deux filtres à commutation, de type série, reliés en série. Les résistances 17 et 19 ne sont pas obligatoires dans ce mode de réalisation du mélangeur, mais elles peuvent servir à modifier le coefficient de pondération introduit par ce mélangeur dans la corrélation des signaux d'entrée.

En référence à la fig. 6, on a représenté un autre mode de réalisation du mélangeur 6 pour lequel les résistances 17 et 19 du mélangeur de la fig. 5 sont simulées par des capacités $C_D$ et $C_E$, commutées périodiquement grâce à des commutateurs 21, 22, 23, 24; ces commutateurs jouent également le rôle du commutateur 15 à deux positions, de la fig. 5. Les commutateurs 21, 23 et le condensateur $C_D$ constituent un circuit équivalent à la résistance 19, tandis que les commutateurs 22, 24 et le condensateur $C_E$ constituent un circuit équivalent à la résistance 17. Les commutateurs 21, 23 sont actionnés alternativement, sans chevauchement de leur durée de fermeture. Il en est de même des commutateurs 22 et 24. La durée de fermeture des commutateurs 21 et 22 permet de régler la valeur de la résistance équivalente correspondante.

Il ressort de ce mode de réalisation du mélangeur de l'ensemble de filtrage de l'invention que toutes les résistances, et particulièrement les résistances $R_E'$ et $R_E''$ communes à l'ensemble des chemins de chacun des filtres de l'ensemble de filtrage, peuvent être simulées par des capacités et des commutateurs; ainsi, l'ensemble de filtrage présente une structure constituée uniquement par des commutateurs et des capacités, qui, en technologie MOS sont particulièrement faciles à intégrer. Les commutateurs peuvent être bien entendu constitués par des transistors à effet de champ. L'ensemble de filtrage de l'invention grâce à l'utilisation de deux filtres à commutation de type série et d'un mélangeur approprié, peut être constitué très facilement par des éléments discrets intégrables. En effet, en utilisant pour les résistances un circuit équivalent comparable au circuit de la fig. 6 (capacités commutées), l'ensemble de filtrage se réduit à une association de composants de deux types: condensateurs et transistors à effet de champ. Le réglage précis de la fréquence centrale et de la largeur de la bande passante peut être effectué très facilement à partir d'une ou plusieurs horloges externes; cette largeur peut être réglée soit en agissant sur le coefficient de pondération introduit par le mélangeur, soit en agissant sur la largeur de la bande passante de chacun des filtres de l'ensemble par réglage des valeurs des résistances qu'ils comprennent.

L'ensemble de filtrage qui vient d'être décrit tout en accroissant de façon importante et réglable la sélectivité du filtre à chemins commutés en conserve les propriétés propres: il est d'une grande insensibilité aux valeurs des éléments qui le composent; il présente une large plage de valeurs de fréquence centrale et de largeur de bande, une réponse en phase passent par 0 à la fréquence centrale; il répond à des signaux périodiques et sa fonction de transfert, en forme de dents de peigne, présente une symétrie autour de chacune des dents de ce peigne, sur un axe linéaire de fréquence. Il est bien évident que cet ensemble de filtrage peut en outre être associé à tous moyens permettant la poursuite en fréquence du signal d'entrée et, notamment, aux moyens qui sont décrits dans la demande de brevet européen n° 80 400 125-3 (EP-AI-0 014 628) au nom du même demandeur.

Cet ensemble de filtrage permet en outre d'éliminer le bruit de fond associé à tout signal périodique, de sélectionner un signal périodique mélangé à un autre signal, de reconnaître une forme d'onde variable en fréquence; il peut être facilement utilisé dans la synthèse de la parole, les télécommunications, la téléphonie, etc... Il peut également permettre d'éliminer les parasites industriels à 50, 80 ou 400 Hz, les parasites créés par le fonctionnement des machines tournantes à fréquence variable; enfin, il peut être utilisé dans l'analyse harmonique et la détection synchrone.

L'invention n'est pas limitée au schéma général de la fig. 3, qui fait intervenir deux filtres à chemins commutés; elle englobe tous les ensembles de filtrage utilisant un filtre à chemins commutés, des moyens permettant de mémoriser le signal contenu dans l'un des chemins pendant un intervalle de temps égal ou voisin de la période du signal utile (ou d'un multiple de cette période), et un circuit mélangeur dont une première entrée reçoit le signal à filtrer et une seconde entrée est reliée à la sortie desdits moyens, ledit circuit mélangeur réalisant ainsi une comparaison entre la valeur instantanée du signal et la valeur qu'avait le signal, une période du signal utile (ou un même multiple de cette période) auparavant.

Un premier exemple d'un tel ensemble de filtrage utilise un filtre à chemins commutés, des moyens de commande de commutation tels que le décalage temporel entre signal d'entrée et signal de sortie de ce filtre, est égal à une demi-période de la composante utile du singal d'entrée et un circuit mélangeur recevant sur une entrée inverseuse le signal de sortie du filtre à chemins commutés et sur une entrée non inverseuse le signal à filtrer.

Ce circuit, plus économique que le précédent, ne donne de résultats équivalents que pour les signaux utiles sur lesquels l'inversion produit le même effet que le décalage d'une demi-période. Pour les autres signaux utiles, il donne un signal filtré présentant une distorsion et peut être utilisé à titre de symétriseur.

Un second exemple utilise un filtre à chemins commutés, des moyens de commande de commutation, tels qu'il n'y ait pas de décalage temporel entre signal d'entrée E et signal de sortie S, une capacité mémoire CM et un jeu de deux interrupteurs 25, 26 connectés selon le schéma de la fig. 7; dans une première position du jeu d'interrupteurs (position 1), le signal stocké dans un des chemins du filtre est introduit dans la capacité mémoire; dans une deuxième position (position 2), le signal d'entrée est comparé au signal mémorisé (correspondant à un échantillonnage effectué sensiblement une période plus tôt) et modifie la valeur du signal stocké dans le même chemin.

Le circuit conforme à ce second exemple n'implique, quant à lui, aucune limitation sur les signaux d'entrée.

## Revendications

1. Ensemble de filtrage de signaux utiles permanents par commutation comprenant un premier filtre (1) à N-chemins à commutation série, apte à recevoir des signaux à filtrer et des moyens (5) pour appliquer à chacun des chemins, des signaux de commande de commutation de ces chemins, un circuit mélangeur (6) dont une première entrée (7) reçoit à un instant considéré, le signal à filtrer et dont une deuxième entrée (8) reçoit, à cet instant considéré, la valeur qu'avait le signal filtré à la sortie (9) de l'ensemble, un instant auparavant, la sortie de ce circuit mélangeur étant reliée à l'entrée (12) dudit premier filtre, caractérisé en ce qu'il comprend au moins un deuxième filtre (2) à N-chemins à commutation série, relié en série avec le premier filtre (1), la sortie du premier filtre étant reliée à l'entrée (4) du deuxième filtre, la sortie du deuxième filtre étant reliée à la sortie (9) de l'ensemble de filtrage, lesdits moyens (5), appliquant aussi des signaux de commande des commutations des chemins du deuxième filtre (2), étant constitués de manière à commander les commutations pour que la somme des décalages temporels entre le signal de sortie du deuxième filtre et le signal d'entrée du premier filtre soit égal à un nombre entier de fractions de périodes T de la composante utile du signal d'entrée du premier filtre.

2. Ensemble de filtrage selon la revendication 1, caractérisé en ce que les deux filtres (1, 2) comprennent un nombre identique N de chemins, chacun des décalages entre les signaux de sortie et les signaux d'entrée de chaque filtre étant égal à un nombre entier de demi-périodes $\dfrac{T}{2}$ de la composante utile du signal d'entrée du premier filtre.

3. Ensemble de filtrage selon la revendication 1, caractérisé en ce que ledit circuit mélangeur (6) comprend un amplificateur opérationnel (10) non inverseur dont la sortie (11) est reliée à l'entrée (12) du premier filtre, cet amplificateur présentant un circuit de contre-réaction ($R_1'$, $R_1''$) sur l'une de ses entrées (13), l'autre entrée (14) de cet amplificateur recevant le signal à filtrer par l'intermédiaire d'une première résistance ($R_E$), cette entrée étant en outre reliée à la sortie du deuxième filtre par l'intermédiaire d'une deuxième résistance ($R_D$), le rapport des valeurs de ces résistances déterminant le coefficient de pondération du mélangeur.

4. Ensemble de filtrage selon la revendication 1, caractérisé en ce que le mélangeur (6) est un commutateur (15) à deux positions commandables électriquement, présentant deux bornes d'entrée (16, 18) et une borne de sortie (20), cette borne de sortie étant reliée à l'entrée du premier filtre (12), la première borne d'entrée (16) du commutateur recevant le signal à filtrer et l'autre borne entrée (18) recevant le signal de sortie du deuxième filtre, la durée relative des temps passés sur les deux positions déterminant le coefficient de pondération du mélangeur.

5. Ensemble de filtrage selon la revendication 4, caractérisé en ce que les deux filtres à commutation (1, 2) sont commandés par les mêmes moyens de commande (5) et en ce que le commutateur (15) est commandé par des moyens de commande de commutation constitués de manière à mettre en communication l'entrée (12) du premier filtre avec la sortie (9) du deuxième filtre pendant une période centrée sur le milieu de l'intervalle de temps pendant lequel est établi un des chemins de chacun des filtres.

6. Ensemble de filtrage selon l'une quelconque des revendications 4 et 5, caractérisé en ce que la première borne d'entrée (16) du commutateur (15) à deux positions reçoit le signal à filtrer par l'intermédiaire d'une première résistance (17), tandis que la deuxième borne d'entrée (18) reçoit le signal de sortie du deuxième filtre (2) par l'intermédiaire d'une deuxième résistance (19), le rapport des valeurs de ces résistances déterminant le coefficient de pondération du signal de sortie du mélangeur (6) dans la corrélation des signaux d'entrée.

7. Ensemble de filtrage selon la revendication 4, caractérisé en ce que l'ensemble formé par le commutateur (15) à deux positions et par les première et deuxième résistances (17, 19) est simulé par des capacités (CD, CE ou CM) commutées périodiquement.

8. Ensemble de filtrage selon l'une quelconque des revendications 1 à 7, caractérisé en ce que les filtres (1, 2) et le mélangeur (6) sont réalisés sous forme de circuits intégrés sur substrat semiconducteur.

9. Ensemble de filtrage selon la revendication 8, caractérisé en ce que lesdits circuits intégrés sont des circuits de type MOS.

## Claims

1. Unit for filtering permanent effective signals by commutation comprising a first N-track series commutation filter (1), adapted to receive signals to be filtered and means (5) for supplying, to each of said tracks, commutation-command signals for said track, a mixing circuit (6) having a first input (7) receiving, at a particular instant, a signal for filtering, and a second input (8) receiving, at said particular instant, the value possessed an instant before by the filtered signal at the output (9) of the unit, the output of the mixing circuit being connected to the input (12) of said first filter, characterized in that it comprises at least one second N-track series commutation filter (2) connected in series with said first filter (1), the output of the first filter being connected to the input (4) of the second filter, the output of the second filter being connected to the output (9) of the filter unit, said means (5) also supplying commutation-command signals to the tracks of the second filter (2), and being adapted to command the commutations so that the sum of elapsed times between the input signal to the first filter and the output signal of the second filter is equal to a whole number of fractions of periods T of the effective component of the input signal to the first filter.

2. Filter unit according to claim 1 characterized in that the two filters (1, 2) have identical numbers of tracks N, each of the elapsed times between the input and output signals of each filter being equal to a whole number of half-periods $\frac{T}{2}$ of the effective component of the input signal to the first filter.

3. Filter unit according to claim 1 characterized in that the said mixing circuit (6) comprises a noninverting operational amplifier (10) whose output (11) ist connected to the input (12) of the first filter, said amplifier having a negative feedback circuit $(R_1', R_1'')$ on one of its inputs (13), the other input (14) of said amplifier receiving the signal to be filtered through a first resistance $(R_E)$, said input additionally being connected to the output of the second filter through a second resistance $(R_D)$, the ratio of the values of said resistances determining the weighting coefficient of the mixing circuit.

4. Filter unit according to claim 1 characterized in that the said mixing circuit (6) is an electronically-commandable two-position commutator (15), having two input terminals (16, 18) and one output terminal (20), said output terminal being connected to the input of the first filter (12), the first input terminal (16) of the commutator receiving the signal to be filtered, and the other input terminal (18) receiving the output signal of the second filter, the relative durations of the time passed in the two positions determining the weighting coefficient of the mixing circuit.

5. Filter unit according to claim 4 characterized in that the two commutation filters (1, 2) are commanded by the same command means (5), and in that the commutator (15) ist commanded by commutation-command means so constituted as to put the input (12) of the first filter in communication with the output (9) of the second filter during a period centred on the middle of the time interval during which one of the tracks of each filter is operative.

6. Filter unit according to either of claims 4 and 5 characterized in that the first input terminal (16) of the two-position commutator (15) receives the signal to be filtered through a first resistance (17), while the second input terminal (18) receives the output signal of the second filter (2) through a second resistance (19), the ratio of the values of the resistances determining the weighting coefficient of the output signal of the mixing circuit (6) in correlation of the input signals.

7. Filter unit according to claim 4 characterized in that the sub-unit formed by the two-position commutator (15) and the first and second resistances (17, 19) is simulated by periodically-commutated capacitors (CD, CE or CM).

8. Filter unit according to any one of claims 1 to 7 characterized in that the filters (1, 2) and the mixing circuit (6) are constituted by integrated circuits on a semiconductor substrate.

9. Filter unit according to claim 8 characterized in that said integrated circuits are MOS type circuits.

**Patentansprüche**

1. Geschaltete Filtereinheit für dauernde Nutzsignale, umfassend ein erstes geschaltetes Serienfilter (1) mit N-Wegen, welches zum Empfangen von zu filternden Signalen geeignet ist, Mittel (5), um an jeden Weg Befehlsschaltsignale für diese Wege zu legen, einen Mischschaltkreis (6), dessen erster Eingang (7) zu einem gegebenen Zeitpunkt das zu filternde Signal und dessen zweiter Eingang (8) zu diesem gegebenen Zeitpunkt den Wert erhält, den das gefilterte Signal am Ausgang (9) der Einheit zu einem davor liegenden Zeitpunkt hatte, wobei der Ausgang des Mischschaltkreises mit dem Eingang (12) des ersten Filters verbunden ist, dadurch gekennzeichnet, dass wenigstens ein zweites geschaltetes Serienfilter (2) mit N-Wegen vorgesehen ist, welches in Reihe mit dem ersten Filter (1) geschaltet ist, dass der Ausgang des ersten Filters mit dem Eingang (4) des zweiten Filters verbunden ist, dass der Ausgang des zweiten Filters mit dem Ausgang (9) der Filtereinheit verbunden ist, dass die Mittel (5), welche auch Befehlsschaltsignale an die Wege des zweiten Filters (2) legen, derart zum Befehlen des Schaltens ausgebildet sind, dass die Summe der zeitlichen Abstände zwischen dem Ausgangssignal des zweiten Filters und dem Eingangssignal des ersten Filters gleich einem ganzzahligen Vielfachen von Bruchteilen der Perioden T der nützlichen Komponente des Eingangssignals des ersten Filters ist.

2. Filtereinheit nach Anspruch 1, dadurch gekennzeichnet, dass die zwei Filter (1, 2) eine identische Anzahl N von Wegen aufweisen, wobei die Abstände zwischen den Ausgangssignalen und den Eingangssignalen bei jedem Filter gleich einem ganzzahligen Vielfachen der Halbperioden $\frac{T}{2}$ der nützlichen Komponente des Eingangssignales des ersten Filters sind.

3. Filtereinheit nach Anspruch 1, dadurch gekennzeichnet, dass der Mischschaltkreis (6) einen nichtinvertierenden Operationsverstärker (10) umfasst, dessen Ausgang (11) mit dem Eingang (12) des ersten Filters verbunden ist, dass dieser Verstärker einen Gegenkopplungszweig $(R_1', R_1'')$ zu einem seiner Eingänge (13) aufweist, dass der andere Eingang (14) dieses Verstärkers das zu filternde Signal über einen ersten Widerstand $(R_E)$ erhält, und dass dieser Eingang ferner mit dem Ausgang des zweiten Filters über einen zweiten Widerstand $(R_D)$ verbunden ist, wobei das Verhältnis der Werte dieser Widerstände den Gewichtskoeffizienten des Mischschaltkreises bestimmt.

4. Filtereinheit nach Anspruch 1, dadurch gekennzeichnet, dass der Mischschaltkreis (6) ein elektrisch steuerbarer Umschalter (15) mit zwei Stellungen ist und zwei Eingangsklemmen (16, 18) und eine Ausgangsklemme (20) aufweist, dass die Ausgangsklemme mit dem Eingang des ersten Filters (12) verbunden ist, dass die erste Eingangsklemme (16) des Umschalters das zu filternde Signal und die andere Eingangsklemme (18) das Ausgangssignal des zweiten Filters erhält und dass die relative Dauer der in den zwei Stellungen verstrichenen Zeit den Gewichtskoeffizienten des Mischschaltkreises bestimmt.

5. Filtereinheit nach Anspruch 4, dadurch gekennzeichnet, dass die zwei geschalteten Filter (1, 2) von den gleichen Steuermitteln (5) steuerbar sind und dass der Umschalter (15) von Steuermitteln zum Umschalten steuerbar ist, welche derart ausgebildet sind, dass der Eingang (12) des ersten Filters mit dem Ausgang (9) des zweiten Filters während einer Periode verbunden ist, die auf die Mitte des Zeitintervalls zentriert ist, während dessen einer der Wege von jedem Filter hergestellt ist.

6. Filtereinheit nach Anspruch 4 oder 5, dadurch gekennzeichnet, dass die erste Eingangsklemme (16) des zwei Positionen aufweisenden Umschalters (15) das zu filternde Signal über einen ersten Widerstand (17) erhält, während die zweite Eingangsklemme (18) das Ausgangssignal des zweiten Filters (2) über einen zweiten Widerstand (19) erhält, und dass das Verhältnis der Werte dieser Widerstände den Gewichtskoeffizienten des Ausgangssignals des Mischschaltkreises (6) in der Korrelation der Eingangssignale festlegt.

7. Filtereinheit nach Anspruch 4, dadurch gekennzeichnet, dass die von dem zwei Stellungen aufweisenden Umschalter (15) und von dem ersten und dem zweiten Widerstand (17, 19) gebildete Einheit von Kondensatoren (CD, CE oder CM) nachgebildet ist, die periodisch geschaltet werden.

8. Filtereinheit nach irgendeinem der Ansprüche 1 bis 7, dadurch gekennzeichnet, dass die Filter (1, 2) und der Mischschaltkreis (6) in der Form von integrierten Schaltkreisen auf einem Halbleitersubstrat ausgebildet sind.

9. Filtereinheit nach Anspruch 8, dadurch gekennzeichnet, dass die integrierten Schaltkreise Schaltkreise von der Art MOS sind.

FIG.1

a

b

FIG.2

# FIG. 3

# FIG.4

FIG.5

FIG.6

FIG.7